Europäisches Patentamt

European Patent Office

Office européen des brevets

(19)

(11) **EP 1 331 487 A1**

(12) **EUROPEAN PATENT APPLICATION**

(43) Date of publication:
**30.07.2003 Bulletin 2003/31**

(51) Int Cl.⁷: **G01R 31/319**, G01R 31/3183

(21) Application number: **02290192.0**

(22) Date of filing: **29.01.2002**

(84) Designated Contracting States:
**AT BE CH CY DE DK ES FI FR GB GR IE IT LI LU
MC NL PT SE TR**
Designated Extension States:
**AL LT LV MK RO SI**

(71) Applicant: **AMI Semiconductor Belgium BVBA
9700 Oudenaarde (BE)**

(72) Inventors:
• **Bauwens, Peter Germain
9700 Oudenaarde (BE)**

• **Chichkov, Anton Velinov
9700 Oudenaarde (BE)**
• **Vanhooren, Ronny
9940 Evergem (BE)**

(74) Representative: **Bird, Ariane et al
Bird Goen & Co,
Klein Dalenstraat 42A
3020 Winksele (BE)**

(54) **Method and device generating integrated circuit test programs**

(57) The invention relates to a process for generating programs aimed to test an integrated circuit. Such a process is characterized in that it comprises the steps of:

determining the test signals to be supplied or measured at the pins of the integrated circuit during its test,

determining the signals which can be provided or measured at the pins of the integrated circuit by the test instruments available during the test, and selecting sets of test instruments which can deliver or measure the test signals.

FIG_2

EP 1 331 487 A1

**Description**

The invention relates to a method and a device generating programs aimed to test integrated circuits.

A test program generation process for integrated circuits (I.C.) differs depending on whether the I.C. uses digital, analogue or both (mixed) technologies. However, broadly speaking, the development of a test program comprises the following steps in all cases:

> First, the I.C. components to be tested are identified. Then, specific test programs are developed for each identified component. Corresponding interfacing hardware between the I.C. and the test instruments is also developed. Finally, these specific programs are assembled into a unique final test program.

The information to be considered at each of these steps increases considerably and becomes overwhelming. Therefore, such operations are as far as possible automatically performed. For instance, significant automation can be used for digital I.C. test program generation since software tools can convert the patterns generated by a design engineer to an appropriate tester language. However, to design an I.C., a plurality of patterns is generally used and the final test program must be assembled manually.

Automatic test program generation process is less developed for analogue I.C. There are only attempts to create automatic tools based on test library developments. More precisely, predefined blocks of test programs are stored in databases and then reused as building blocks to compose a complete test program.

Nevertheless, these provided block programs must be continuously adapted since they are written considering specific inputs and outputs of tested components whereas, in general, these inputs and outputs are not always available to be connected to test equipment pins. Therefore, components placed between test equipment pins and tested component pins must be manually taken into account to develop the building blocks. Indeed, none of known automatic tools delivers test programs which take into account the environment of a tested component, i.e. the components placed between the test equipment pins and the tested component to adapt a generated program. Disappointingly, considering prior and following components is extremely time consuming since a high number of components might have to be considered, and the predefined test blocks have to be rewritten.

It appears that current test program generation approach is not optimal since it includes extensive manual operations which must consider cascades of prior and following components for each tested component as well as hardware and software interfaces which vary according to the tester.

Moreover, each developed test program cannot be re-used for further developments since it is specific to each circuit and tester topology (a tester being the whole group of test instruments). For instance, the alteration of the position of a component requires to change the test program.

Most importantly, analogue circuits cannot be developed automatically since the operation of an analogue component cannot be modeled as exactly and easily as binary operations.

The invention provides an automatic process generating test programs which resolves at least one of these problems. It concerns a process for generating programs aimed to test digital, analogues and/or mixed signal integrated circuits comprising the steps of:

> determining the test signals to be supplied or measured at the pins of the integrated circuit during its test,
> determining the signals which can be provided or measured at the pins of the integrated circuit by the test instruments available during the test, and
> selecting sets of test instruments which can deliver or measure the test signals.

Thus, the program generation is not operated at the first step by taking into account all the technical parameters defining a test instrument. At the opposite, instruments are selected, in a first step, considering only their behavior, i. e. the signals they can perform or measure.

Thereafter, each selected "behavior instrument" i.e. instrument selected for its signal characteristics is implemented through a plurality of combinations of automatic test equipment instruments (hardware), software routines and/ or custom circuits on the interface board providing the needed behavior.

For that purpose, further technical criteria are defined which comprise similar criteria to the first criteria (behavior) plus an increasing number of technical parameters, e.g. range or accuracy, to determine the type of implementation of the test instrument.

These further criteria can be used to optimize a better operation of the test machine regarding, for example, the number of instruments required during the test or the test duration.

Once the test instruments and their operations have been selected, the last step is the programming of the instruments. All needed parameters are available by this step.

It has to be noted that the prior art does not address test program generation from this approach and, for that reason, does not provide any similar process.

According to this method, test program generation delays are strongly reduced, usually from months to days' periods.

In an embodiment, at least one of the following parameters is used to determine the test signals at the pins of the integrated circuit : the function (measured or supplied), the nature (current or voltage) and the variability (DC or AC) of the signal.

According to one embodiment, the parameters used to determine the signals provided or measured by the test instruments are matching the parameters used to determine the signals to be supplied or measured at the pins of the tested integrated circuit.

In an embodiment, to select sets of test instruments which can deliver or measure the test signals, the method comprises the following steps:

a- A first operating parameter or group of first operating parameters is (are) selected for all the test instruments, and this parameter or group of parameters is memorized,

b- Using this first operating parameter or group of operating parameter(s), a first test instrument or group of test instruments operating accordingly to this parameter is selected,

c- Step a- is repeated for a following operating parameter(s) or group(s) of parameters, the following selected test instrument, or group of test instruments, being gathered with the first selected test instrument or group of test instruments into a set.

According to one embodiment, the operating parameter(s) is (are) selected in the group comprising: the Digital or Analog nature of the instruments, the accuracy of the instruments, the range of instruments, the localization of the instruments toward integrated circuit or toward other test instruments, the availability of the instruments, the duration of the test, the accuracy of the test and the power consumption of the test.

In an embodiment, the selected set of test instruments provides a plurality of similar group of test signals, the selected sets of tests instruments providing the group of test signals to be supplied or measured.

According to one embodiment, the generation of the program comprises development levels:

a first level wherein test instruments are only selected according to the signals they can deliver and/or measure,

a second level wherein the test instruments are selected in function of their localization,

a third level wherein test instruments are selected according to their software/hardware composition.

The invention concerns also an application of the process according to any of the prior embodiments to the generation of test programs for analog integrated circuits, for digital integrated circuits, or analog and digital integrated circuits.

Features and advantages of the invention will appear with the description of certain of its embodiments, this description being made in connection with the following drawings wherein:

figure 1 represents an integrated circuit for which a test program is generated accordingly to the invention, and

figure 2 is a diagram representing different steps of a test program generation accordingly to the invention.

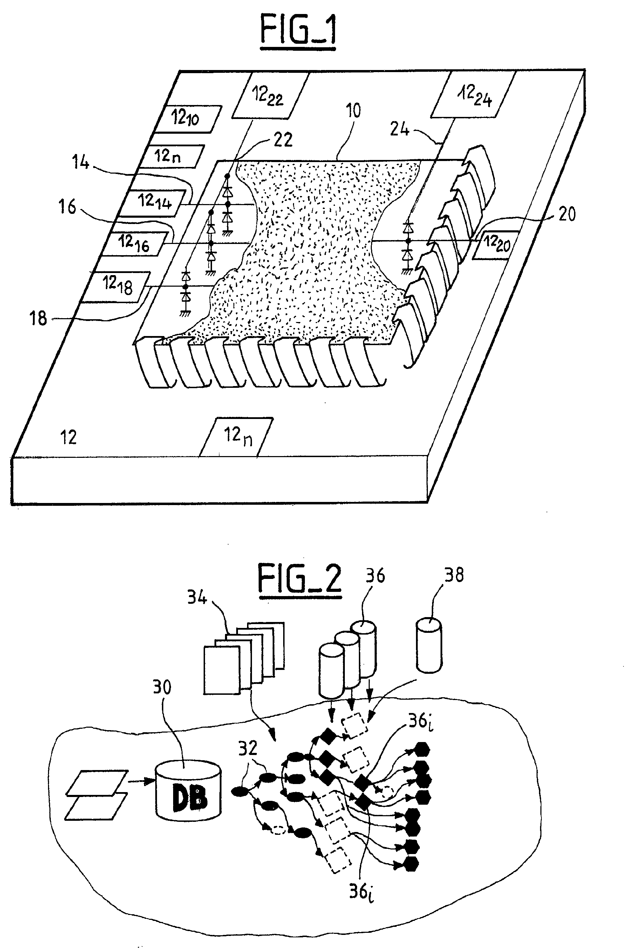

To illustrate the invention, a program will be developed to test the I.C. 10 represented in figure 1. This test will be performed by a tester 12 comprising a plurality of test instruments $12_{10}$, $12_{12}$ ..., $12_{26}$, ... $12_n$.

The whole group of actions operated during the test at the external pins 14, 16, 18, 20, 22 and 24 of the I.C. 10 are determined by the test engineer. These actions, represented by signals to be measured or delivered, are memorized in a database 30 (figure 2). In this example, the test of I.C. 10 requires supplying current trough inputs 12, 14 and 16 and output 20 of the I.C. The measurement of the resulting voltages at each current supplied I.C. pin and the comparison between measured voltages and expected values conclude the test.

More precisely, to perform correctly this test, a test current equal to 100 µa with variations lesser than 10 µa should be delivered at each one of the pins 14, 16, 18 and 20. Thereafter, the test will be successful if a measured voltage at those pins is comprised between 0.2 and 1.6 volts while the current is supplied at the pin.

Pins 22 and 24 are the power supply pins of the integrated circuit 10. During the test, they should be maintained at 0 volt.

Based on this information, automatic program generation can be performed accordingly to the invention. To start with, the information defining the signals to be applied at external pins 14, 16, 18, 20, 22 and 24 of the I.C. 10 during the test, memorized in a database 30, is considered in order to determine which instruments of the tester 12 can deliver or measure these test signals.

For that purpose, technical characteristics are used to define the behavior or the signals that each test instrument can perform, such as whether signals can be delivered and/or measured, whether an instrument can operate with current and/or voltage and whether the signals are direct (DC) or alternative (AC). These technical characteristics are memorized in a database 34.

Therefrom, sets $32_1$, $32_2$,..., $32_n$ of behavioral instruments (B.I.), i.e. instruments which are only defined by their behavior, are determined by matching the information of database 30 - the signals to be applied or measured - with the information of database 34 - the signals which each test instrument are able to perform.

Table 1 shows how the first instruments defined for this program generation are identified in this example.

Table 1

| Line number | Event Instr | Name | Action | Type | Appl Type | Pins | Params | Params |
|---|---|---|---|---|---|---|---|---|
| 101 | EVT | DeclareDouble | | | | | Double=DiodUp [6] | |
| 102 | B.I. | ForceVDCSupply | ForceV | DC | Supply | 22 | v=0v | |
| 103 | B.I. | ForceVDCSupply | ForceV | DC | Supply | 24 | v=0v | |
| 104 | B.I. | ForceIDCDigital | ForceI | DC | Digital | 14 | I=100ua | 0.0v<ForceRange<1.6v |
| 105 | B.I. | MeasureVDCDigital | MeasureV | DC | Digital | 14 | v=DiodUp[0] | 0.0v<MeasureRange<1.6v |
| 106 | EVT | Test | | | | | test=DiodUp[0] | 0.2v<TestLimits<1.6v |
| 107 | B.I. | ForceIDCDontCare | ForceI | DC | Dontcare | 14 | | |
| 108 | B.I. | ForceIDCDigital | ForceI | DC | Digital | 16 | I=100ua | 0.0v<ForceRange<1.6v |
| 109 | B.I. | MeasureVDCDigital | MeasureV | DC | Digital | 16 | v=DiodUp[1] | 0.0v<MeasureRange<1.6v |
| 110 | EVT | Test | | | | | test=DiodUp[1] | 0.2v<TestLimits<1.6v |
| 111 | B.I. | ForceIDCDontCare | ForceI | DC | Dontcare | 16 | | |
| 112 | B.I. | ForceIDCDigital | ForceI | DC | Digital | 18 | I=100ua | 0.0v<ForceRange<1.6v |
| 113 | B.I. | MeasureVDCDigital | MeasureV | DC | Digital | 18 | v=DiodUp[2] | 0.0v<MeasureRange<1.6v |
| 114 | EVT | Test | | | | | test=DiodUp[2] | 0.2v<TestLimits<1.6v |
| 115 | B.I. | ForceIDCDontCare | ForceI | DC | Dontcare | 18 | | |
| 116 | B.I. | ForceIDCDigital | ForceI | DC | Digital | 20 | I=100ua | 0.0v<ForceRange<1.6v |
| 117 | B.I. | MeasureVDCDigital | MeasureV | DC | Digital | 20 | v=DiodUp[3] | 0.0v<MeasureRange<1.6v |
| 118 | EVT | Test | | | | | 20 | test=DiodUp[3] | 0.2v<TestLimits<1.6v |

Table 1 is divided in columns indicating the information considered at this step of the test generation process. The column "Event/Instr" precises the category of instrument or operation considered at each pin 14, 16, 18, 20, 22 and 24 at this level of the program generation. At this first step of the generation, only behavioral instruments "B.I." are considered at each pin for each operation "EVT" to be performed.

The column "Name" indicates an identification code for each selected instruments.

The column "Action" identifies the operation performed by each selected B.I.. In this example, a behavioral instrument forces or measures a voltage (V) or a current (I).

The columns "Type" and "Appl Type" define some aspects of the application of the considered instrument. In this case, it indicates that the test instruments operate with continuous current/voltage.

A column "Pins" of Table 1 indicates which I.C. pin is concerned by the parameters of each line.

The column "Params" indicates the information taken into account to characterize each selected instrument at one pin. In this preferred embodiment, these parameters are the value of the voltage and/or current applied or measured, the range of the test operation and/or the accuracy of the test instrument.

As previously indicated, pins 22 and 24 are power supply pins which will be maintained at 0 volt during the test. These actions are represented by lines 102 and 103 of table 1.

Also, current should be equal to 100 μa for pin 12 with variations less than 10 μa in a range of operation comprised between 0.0 and 1.6 V. This action is represented by line 104.

Line 105 indicates that a behavioral instrument will perform a measurement of the voltage at pin 14, this measurement having as an additional characteristic that the range of the voltage should be between 0.2 and 1.6 volts, and the expected accuracy lesser than 8 mV.

Line 106 indicates that a test is to be programmed to compare data, and more precisely, to compare a measured voltage at pin 14 versus an expected voltage.

The operations described in lines 102, 103, 104, 105 and 106 relate to the signals apply to pins 14, 22 and 24 and measured at pin 14. Indeed, the conditions of the test operation at pin 14 (lines 104 to 107) are repeated for pin 16 at lines 108 to 111, for pin 18 at lines 112 to to 115 and for the pin 20 at lines 116 to 118.

At this level, the B.I. description is not detailed enough to be implemented directly i.e. to make a program since it does not provide information such as the localization of each test instrument or the chronology of the test. Searching for appropriate implementation of every B.I. is the next step which leads to Virtual Instruments (V.I.) which are defined by more parameters and implementing details than B.I.s. Indeed, a V.I. is a set of components clearly identified of software blocks, circuitry on the interface board or direct tester instrument.

In order to perform the B.I./V.I. transition, the set of all possible implementations of each B.I. into a V.I. is built using the information in a database 36. This database 36 contains information about the available test instruments with added technical parameters by contrast to database 34. More precisely, through database 36, test instruments are considered as black boxes with clearly localized inputs and outputs that will deliver, or measure, a predefined signal.

Sets $36_1$, $36_2$, ...$36_n$ are created from each set $32_i$. Each set $36_k$ forms a group called solution space which comprises all the different combinations of the test instruments which allow to perform the test. Algorithms using as criteria additional signal parameters and test requirements are used to find the best fit i.e. the best combination of test instruments to perform the test, for instance by reducing the test duration.

In this case, accuracy and range of each instrument operation are part of the additional parameters taking into account.

In the following two tables 1b and 2, the transformation of a B.I. into a V.I. is shown. It should be noticed that four B.I.s and one event have been implemented in only three V.I.'s. Indeed, during the search for best fit some optimizations are done and, in this case, an instrument in the tester that can deliver current while measuring a voltage (Force_I), (Measure_V) (while doing the test) at the same time will be preferred to any combination of two different instruments making separately each operation.

A V.I. comprises all the parameters defining a B.I., adding the specific ones nearly considered at this level.

Table 1b and 2: **B.I./V.I. transformation**

Table 1b

| Line | Event/Instr | Name | Action | type | Appl_type | Pins | Param | Param |
|---|---|---|---|---|---|---|---|---|
| 102 | B.I. | ForceVDCSupply | ForceV | DC | Supply | 22 | V=0v | |
| 103 | B.I. | ForceVDCSupply | ForceV | DC | Supply | 24 | V=0v | |
| 104 | B.I. | ForceIDCDigital | ForceI | DC | Digital | 14 | I=100ua | 0.0v<Force Range<1.6v |
| 105 | B.I. | MeasureVDCDigital | MeasureV | DC | Digital | 14 | V=DiodUp[0] | 0.0v<Measure Range<1.6v |

Table 2

| Line | Event/ Instr | Name (V + component) | Action | Type | Appl_type | Pins | Param | param |
|------|------|------|------|------|------|------|------|------|
| 206 | VI | V.I._Dutsrc:C_src | ForceV | DC | Supply | 22 | As in table 1 (line 102) | Range, Accuracy |
| 207 | VI | V.I._Dutsrc:C_src | ForceV | DC | Supply | 24 | As in table 1 (line 103) | Range, Accuracy |
| 208 | V.I. | V.I. _ForceIMeasureV TestDigitalParallel: C_openshort | ForceI MeasureV Test | DC | Digital | 14 | As in table 1 (lines 104, 105) | Range, Accuracy |

While in table 1b the selected test instruments are characterized as Behavior Instruments, the instruments considered in table 2 are Virtual Instruments where added information about the selected instruments is considered.

To optimize the test, it is supposed that a maximum of test operations should be performed simultaneously. Therefrom, the automatic generation process regroups the operations which can be performed simultaneously by a single test instrument.

This transformation requires special attention. Indeed, a plurality of instruments might be able to deliver or measure a signal characterized in the database 30, leading thereby to a plurality of selections.

For instance, considering that the test requires measuring voltages at p different pins while n (n>p) test instruments can measure a voltage, it appears that: $A_n^p$ selections are possible for that operation. Moreover, if the test comprises other operations with different numbers $A_n^p, A_{n'}^{p'} .... A_{ni}^{pi}$ of test instrument selections for each one of them, an important number of global test instrument selections are theoretically possible i.e. $A_n^p * A_{n'}^{p'} * ...* A_{ni}^{pi}$ selections for the whole test.

One Virtual Instrument comprises a plurality of different elements (software, hardware, etc) associated with a plurality of pins. Thus some selections might appear possible to be operated when considering all the details of the implementation. For instance, if a voltage has to be delivered while a current is measured during the test, an instrument performing both operations is firstly selected for each of these operations.

Nevertheless, this instrument might not be able to perform these operations simultaneously or at the required pins - chronological and topological parameters have not been taken into account yet. Therefore to improve the speed of testing and to ensure the optimal use of the tester instruments, at each generation level, optimization algorithms are used to take into account "implementation parameters", i.e. parameters which will command the operation of the test instrument.

This way, each of the B.I. is completed progressively while passing from one level of generation to a more concrete one, every level bringing more parameters to the definition of a test instrument. Indeed, the level that follows the level of V.I.'s is the level of Hardware Instruments (H.I.). To transform a V.I. in set of hardware instruments (HI), a database 38, which comprises more parameters characterizing each test instrument, is considered.

This database 38 contains information which specifies the precise composition hardware/software of each virtual instrument. This way, the operations performed by software(s) means (SW) are identified and the required software's can be provided.

Similarly, necessary hardware (HW) means must be characterized in order to develop lines of program to use them. Finally, a schedule (time) for the whole test operations must be set. In case different schedules are possible, different programs might be delivered so that test engineers optimize the schedule following specific criteria.

It is important to note that the operations at the pins 22 and 24 do not require scheduling since the voltage must be maintained at 0 volt during the whole test, whereas the operations regarding the pins must be scheduled since a single test instrument must operate the test.

Table 3 shows the transformation of the V.I. of table 2 into H.I.

Table 2

| Line | Event/ Instr | Name | Action | Type | Appl_type | Pins | Param | Added Param |
|---|---|---|---|---|---|---|---|---|
| 206 | VI | V.I._Dutsrc:C_src | ForceV | DC | Supply | 22 | As in table 1 (line 102) | Range, Accuracy |
| 207 | VI | V.I._Dutsrc:C_src | ForceV | DC | Supply | 24 | As in table 1 (line 103) | Range, Accuracy |
| 208 | V.I. | V.I._ForceIMeasureVTestDigitalParallel:C_openshort | Forcel MeasureV Test | DC | Digital | 14 | As in table 1 (lines 104, 105) | Range, Accuracy |

Table 3

| Line | Event/ Instr | Name | Action | type | appl_type | Pins | Param | Hard/ Software |
|------|-----------|------|--------|------|-----------|------|-------|----------------|
| 306 | HI | dutsrc | ForceV | DC | Supply | 22 | As in table 2, line 206 | Data |
| 307 | HI | dutsrc | ForceV | DC | Supply | 24 | As in table 2, line 207 | Data' |
| 308 | HI | open_short | ForceIMeasureVTest | DC | Digital | 14 | As in table 2, line 208 | Data" |

At this abstraction level, some additional information is needed to identify the physical connections between the test instruments and the I.C. pins provided by the hardware interface board. This board is defined and developed by the test engineer but some freedom to exchange equivalent instruments is given to the layout tool. The information of the resulting interconnections is very important for the test program generation. It defines which tester channel is physically connected to which IC pin. This information is transferred by automatic link with the layout development software.

It has to be underlined that the choice - to have as far as possible the operations relating to one pin performed by a single test instrument - might be modified for another test, leading thereby to another test program.

It is also possible to determine that a low number of test instruments should be used even if different pins are concerned. In this case, it has to be observed that the operations performed at pins 12, 14 and 16 are identical.

It now appears that the program generation process has selected test instruments capable of testing the integrated circuit. Advantageously, this selection has optimized a test criterion to minimize the number of instruments used during the test.

Therefrom, for the purpose of delivering a test program which can operate the test instruments, it is only required to develop the specific statements controlling this instrument. Based on this information, a test program performing the required test of the integrated circuit can be obtained through known methods of program generation.

Indeed, at this level of the process, the instruments which are going to perform test operations are clearly identified. Moreover, the schedule of these operations is set and the required hardware and software elements are identified.

## Claims

1.   A process for generating programs aimed to test an integrated circuit comprising the steps of :

   determining the test signals to be supplied or measured at the pins of the integrated circuit during its test,
   determining the signals which can be provided or measured at the pins of the integrated circuit by the test instruments available during the test, and
   selecting sets of test instruments which can deliver or measure the test signals.

2.   Process according to claim 1 wherein at least one of the following parameters is used to determine the test signals at the pins of the integrated circuit : the function (measured or supplied), the nature (current or voltage) and the variability (DC or AC) of the signal.

3.   Process according to claim 2 wherein the parameters used to determine the signals provided or measured by the test instruments are matching the parameters used to determine the signals to be supplied or measured at the pins of the tested integrated circuit.

4.   Process according to claim 1, 2 or 3 wherein in order to select sets of test instruments which can deliver or measure the test signals, it comprises the following steps:

   a- A first operating parameter or group of first operating parameters is (are) selected for all the test instruments, and this parameter or group of parameters is memorized,

b- Using this first operating parameter or group of operating parameter(s), a first test instrument or group of test instruments operating accordingly to this parameter is selected,

c- Step a- is repeated for a following operating parameter(s), or group(s) of parameters, the following selected test instrument, or group of test instruments, being gathered with the first selected test instrument, or group of test instruments, into a set.

5. Process according to claim 4 wherein the operating parameter(s) is (are) selected in the group comprising: the Digital or Analog nature of the instruments, the accuracy of the instruments, the range of instruments, the localization of the instruments toward integrated circuit or toward other test instruments, the availability of the instruments, the duration of the test, the accuracy of the test and the power consumption of the test.

6. Process according to claim 4 or 5 wherein the selected set of test instruments provides a plurality of similar group of test signals, the selected sets of tests instruments providing the group of test signals to be supplied or measured.

7. Process according to any of the prior claims wherein the generation of the program comprises development levels:

a first level wherein test instruments are only selected according to the signals they can deliver and/or measure,

a second level wherein the test instruments are selected in function of their localization,

a third level wherein test instruments are selected according to their software/hardware composition.

8. Application of the process according to any of the prior claims to the generation of test programs for analog integrated circuits.

9. Application of the process according to any of the claims 1 to 7 to the generation of test programs for digital integrated circuits.

10. Application of the process according to any of the claims 1 to 7 to the generation of test programs for analog and digital integrated circuits.

## FIG_1

## FIG_2

**European Patent Office**

**EUROPEAN SEARCH REPORT**

Application Number

EP 02 29 0192

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | EP 0 552 532 A (HEWLETT PACKARD CO) 28 July 1993 (1993-07-28) * claims 1,2 * ----- | 1,4 | G01R31/319 G01R31/3183 |

TECHNICAL FIELDS SEARCHED (Int.Cl.7)

G01R

The present search report has been drawn up for all claims

| Place of search | Date of completion of the search | Examiner |
|---|---|---|
| THE HAGUE | 7 January 2003 | Six, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.** EP 02 29 0192

This annex lists the patent family members relating to the patent documents cited in the above-mentioned European search report.
The members are as contained in the European Patent Office EDP file on
The European Patent Office is in no way liable for these particulars which are merely given for the purpose of information.

07-01-2003

| Patent document cited in search report | | Publication date | Patent family member(s) | | Publication date |
|---|---|---|---|---|---|
| EP 0552532 | A | 28-07-1993 | US | 5323108 A | 21-06-1994 |
| | | | DE | 69226937 D1 | 15-10-1998 |
| | | | DE | 69226937 T2 | 04-02-1999 |
| | | | EP | 0552532 A2 | 28-07-1993 |
| | | | JP | 3174182 B2 | 11-06-2001 |
| | | | JP | 6018635 A | 28-01-1994 |

For more details about this annex : see Official Journal of the European Patent Office, No. 12/82